(19) Europäisches Patentamt
European Patent Office
Office européen des brevets

(11) Numéro de publication: **0 033 043**
**B1**

(12) **FASCICULE DE BREVET EUROPEEN**

(45) Date de publication du fascicule du brevet: **11.01.84**

(21) Numéro de dépôt: **80401624.4**

(22) Date de dépôt: **13.11.80**

(51) Int. Cl.³: **G 03 C 1/68**, C 08 G 59/40, C 08 G 59/32, C 08 G 75/08, C 08 F 291/18, C 08 F 265/04, C 03 C 25/02

# (54) Composition photopolymérisable comportant un cycle thiirane, et procédé de revêtement d'une fibre optique utilisant une telle composition.

(30) Priorité: **27.12.79 FR 7931799**

(43) Date de publication de la demande: **05.08.81 Bulletin 81/31**

(45) Mention de la délivrance du brevet: **11.01.84 Bulletin 84/2**

(84) Etats contractants désignés: **AT BE CH DE GB IT LI NL**

(56) Documents cités:
**CH - A - 380 374**
**DE - A - 1 569 249**
**DE - A - 1 813 011**
**DE - A - 2 116 591**
**FR - A - 1 390 196**
**FR - A - 2 210 638**
**FR - A - 2 269 538**
**FR - A - 2 352 007**
**FR - A - 2 382 709**
**US - A - 2 673 151**
**US - A - 3 055 758**
**US - A - 4 099 837**
**US - A - 4 125 644**

**CHEMICAL ABSTRACTS, vol. 86, no. 22, 30 mai 1977, pages 85/86, abrégé 157113n, COLUMBUS, OHIO (US)**

(73) Titulaire: **LIGNES TELEGRAPHIQUES ET TELEPHONIQUES L.T.T., 1, rue Charles Bourseul, F-78702 Conflans-Ste-Honorine (FR)**

(72) Inventeur: **Eranian, Armand, "THOMSON-CSF" SCPI 173, bld Haussmann, F-75360 Paris Cedex 08 (FR)**
Inventeur: **Dubois, Jean-Claude, "THOMSON-CSF" SCPI 173, bld Haussmann, F-75360 Paris Cedex 08 (FR)**
Inventeur: **Faure, Michel, "THOMSON-CSF" SCPI 173, bld Haussmann, F-75360 Paris Cedex 08 (FR)**
Inventeur: **Paimblant, Paul, "THOMSON-CSF" SCPI 173, bld Haussmann, F-75360 Paris Cedex 08 (FR)**

(74) Mandataire: **Taboureau, James et al, THOMSON-CSF SCPI 173, Bld Haussmann, F-75379 Paris Cedex 08 (FR)**

(56) Documents cités: (suite)
**Z.W. WICKS et al.: "Utilization of linseed oil derivatives in ultraviolet systems. II Synthesis and evaluation of sulfur derivatives"**

**Le dossier contient des informations techniques présentées postérieurement au dépôt de la demande et ne figurant pas dans le présent fascicule.**

**EP 0 033 043 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

BUNDESDRUCKEREI BERLIN

# Composition photopolymérisable comportant un cycle thiirane, et procédé de revêtement d'une fibre optique utilisant une telle composition

L'invention concerne une composition photopolymérisable comportant des substances organiques dont l'une au moins contient un cycle thiirane, cette composition étant utilisable pour revêtir une fibre optique afin d'assurer sa protection primaire. L'invention concerne également le procédé d'application d'une telle composition.

On sait qu'il est nécessaire, au cours même du tirage d'une fibre optique à partir d'une préforme de verre, de recouvrir la fibre d'un revêtement de protection dit primaire permettant de conserver les propriétés mécaniques de la fibre et d'obtenir, pour la fibre ainsi revêtue, une grande résistance à la traction, utile pour la confection de câbles optiques.

Selon un procédé connu, on utilise, pour le revêtement primaire d'une fibre optique, une composition à base d'époxy-acrylate, polymérisable par irradiation ultraviolette, capable de durcir ou de commencer à durcir assez rapidement pour que l'on puisse effectuer le revêtement en cours de tirage avant d'enrouler la fibre sur un tambour de stockage. On fait, à cet effet, défiler la fibre optique sortant du dispositif d'enduction entre deux tubes à rayons ultraviolets par exemple du type à vapeur de mercure. Toutefois, le durcissement obtenu par cette méthode ne correspond qu'à une réticulation incomplète de la composition et donc à des propriétés mécaniques imparfaites. Il est nécessaire de faire subir à la fibre, un traitement ultérieur de type thermique de durée non négligeable, ce qui entraîne une complication du procédé de fabrication et des dépenses d'énergie supplémentaires.

L'invention tend à remédier à ce dernier inconvénient en utilisant une composition dont la réticulation n'exige pas de traitement thermique complémentaire.

Parmi les documents connus, le brevet US-A-4 099 837 décrit un procédé d'enduction d'une fibre optique au moyen d'un produit de polymérisation d'un mélange de prépolymères, esters de l'acide acrylique, dont en particulier des époxy, en présence d'un seul sensibilisateur au rayonnement ultraviolet, de type benzoïne.

Dans un domaine voisin, la demanderesse avait déjà observé l'intérêt des résines comportant un cycle thiirane. La demande de brevet FR-A-2 352 007 révele une résine de masquage pour la microélectronique, composée d'un copolymère de 2,3 épithiopropylméthacrylate et monomère vinylique de type acrylique, en présence d'azobisisobutyronitrile comme catalyseur. La demande de brevet FR-A-2 382 709 utilise des produits de départ proches de ceux cités cidessus, mais avec un sel d'aryldiazonium ou d'aryliodinium comme sensibilisateur photonique.

Selon l'invention, le cycle thiirane se trouve soit dans un prépolymère, soit dans un monomère, mais la copolymérisation se fait au moyen de deux catalyseurs, un à caractère radicalaire, un à caractère ionique: leur combinaison accélère la copolymérisation et permet d'enrouler une fibre optique quelques secondes seulement après son enduction.

La composition photopolymérisable suivant l'invention est du type durcissable sous l'effet d'un rayonnement photonique ultra-violet. Elle est caractérisée en ce qu'elle comprend au moins un polymère réactif à ce rayonnement dont la formule chimique comporte au moins un cycle thiirane ou présente une insaturation éthylénique, au moins un monomère vinylique dont la formule chimique comporte un cycle thiirane dans le cas où ledit polymère réactif n'en comporte pas lui-même, et au moins deux photo-initiateurs dont l'un a un caractère radicalaire et l'autre un caractère ionique.

Dans ce qui suit, on désigne par polymère réactif tout polymère contenant un cycle thiirane ou une insaturation de type éthylénique.

Trois types de composition sont donc possibles pour obtenir une composition suivant l'invention avant addition des photo-initiateurs. En effet, si l'on désigne par:

- A1 la catégorie des polymères à cycle thiirane;
- A2 la catégorie des autres polymères réactifs à insaturation éthylénique;
- B1 la catégorie des monomères vinyliques à cycle thiirane;
- B2 la catégorie des monomères vinyliques sans cycle thiirane;

les trois types de compositions s'obtiennement en réalisant les combinaisons:

A1B1, A1B2 et A2B1 (le type A2B2 étant exclu).

Dans la description qui suit, on donne des exemples de compositions des différents types ainsi que des moyens de fabrication de leurs constituants lorsque ceux-ci ne sont pas disponibles commercialement. En outre, on décrit un exemple d'application de l'invention.

Les figures 1 à 17 sont des formules développées de composés organiques entrant dans les compositions selon l'invention.

Les polymères réactifs sont soit des polymères de faible poids moléculaire soit des polymères de poids moléculaire plus élevé mais solubles dans au moins un des monomères.

Les monomères sont choisis parmi ceux qui sont liquides à la température ambiante.

## Exemples de polymeres reactifs

La figure 1 donne la formule développée du polyvinylcinnamate (catégorie A2).

La figure 2 donne la formule développée d'un composé polyacrylique (R = H) ou polyméthacrylique ($R = CH_3$) comportant un radical

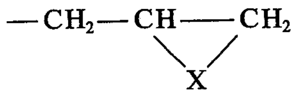

dans lequel X est S (catégorie A1) ou O, C (catégorie A2).

La figure 3 donne la formule développée d'un polymère de la figure 2 modifié totalement par l'acide acrylique (R' = H) ou par l'acide méthacrylique ($R' = CH_3$).

La figure 4 donne la formule développée de polyacrylates (R = H) ou polyméthacrylates ($R = CH_3$) analogues à ceux de la figure 2, partiellement modifiés par l'acide acrylique (R' = H) ou par l'acide méthacrylique ($R' = CH_3$) avec $0 < n_0 < n$.

La figure 5 donne la formule de polymères époxy (X = O: catégorie A2) ou thiirane (X = S: catégorie A1) obtenus à partir du bisphénol A avec $0 \leq n \leq n_1$; $n_1$ étant une valeur limite suffisamment faible pour que la réaction de substitution de l'oxygène des cycles époxy par le soufre soit effective.

La figure 6 fournit la formule des polymères de la figure 5 après estérification totale par l'acide acrylique (R' = H) ou par l'acide méthacrylique ($R' = CH_3$).

Les mêmes polymères époxy et thiirane partiellement estérifiés peuvent également être utilisés.

La figure 7 représente la formule d'autres polymères époxy (X = O: catégorie A2) et thiirane (X = S: catégorie A1) obtenus à partir d'alcanediols, par exemple du butanediol (n' = 4) ou de l'hexanediol (n' = 6), avec $0 \leq n \leq n_1$, $n_1$, étant une valeur limite suffisamment faible pour que la réaction de substitution de l'oxygène des cycles époxy par le soufre sont effective.

La figure 8 montre la formule des polymères de la figure 7 après estérification par l'acide acrylique (R' = H) ou par l'acide méthacrylique ($R' = CH_3$).

On obtient de façon analogue les polymères du même type après estérification partielle.

Lorsque X représente un atome d'oxygéne, les polymères selon les formules 2, 5 et 7 présent une insaturation éthylénique.

## Exemples de monomeres vinyliques

Les monomères vinyliques appropriés sont généralement des monoesters, diesters, triesters et tétraesters des acides acrylique et méthacrylique; une préférence étant accordée aux esters de l'acide acrylique qui sont plus réactifs.

Ceux qui ne sont pas disponibles commercialement peuvent être facilement obtenus par estérification des acides acrylique ou méthacrylique par les monoalcools ou polyalcools correspondants suivant la réaction générique:

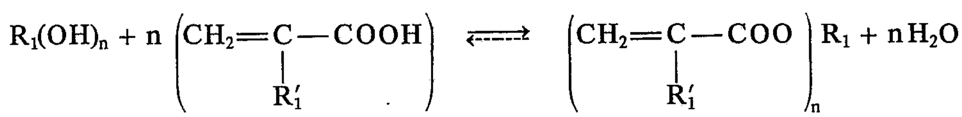

dans laquelle:

$R_1$ est un radical hydrocarboné;
$R'_1$ est un atome d'hydrogène ou un radical $CH_3$;
n est un entier de 1 à 4.

La figure 9 illustre une famille de composés organiques dans laquelle:

- en remplaçant X par O et R par H, on obtient l'acrylate de glycidyle;
- en remplaçant X par S et R par H, on a l'acrylate d'épithio -2, -3 propyle;
- en remplaçant R par $CH_3$ et X par O, on a le méthacrylate de glycidyle;
- en remplaçant R par $CH_3$ et X par S, on a le méthacrylate d'épithio-2, -3 propyle.

La figure 10 illustre une famille de composés organiques dans laquelle:

- en remplaçant R par $CH_3$ et en faisant n égal à 1, on a le diméthacrylate d'éthylène glycol;
- en remplaçant R par H et en faisant n égal à 2, on a le diacrylate de diéthylène glycol;
- en remplaçant R par H et en faisant n égal à 3, on a le diacrylate de triéthylène glycol.

La figure 11 illustre une famille de composés organiques dans laquelle:

- en faisant n égal à 4, on a le diacrylate de butanediol-1, -4;
- en faisant n égal à 6, on a le diacrylate d'hexanediol-1, -6.

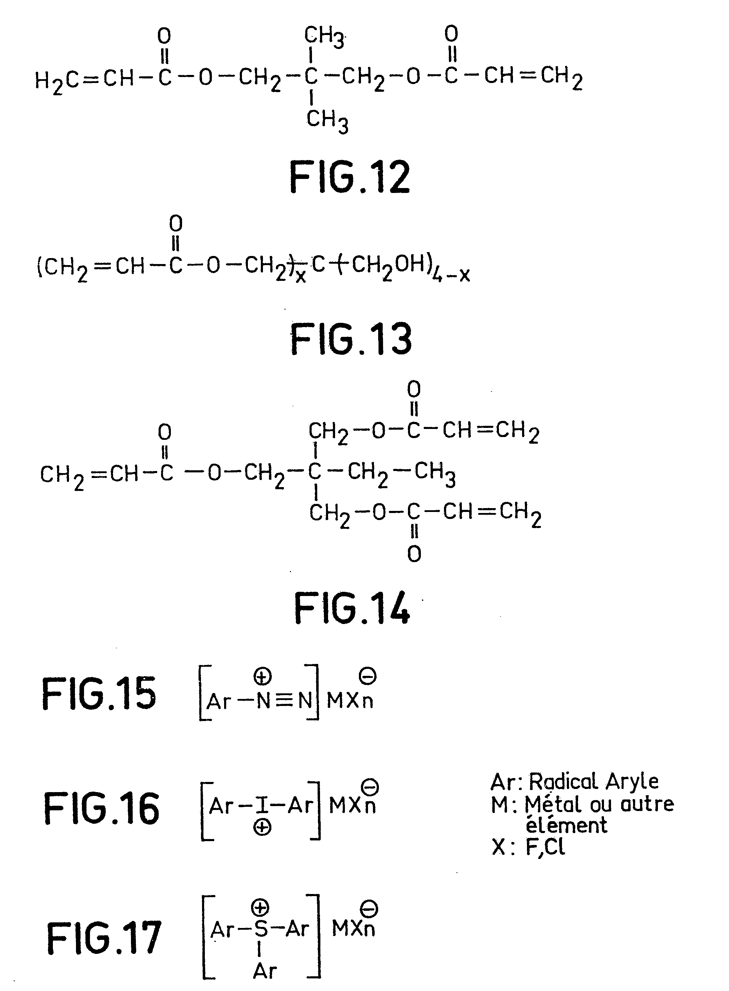

La figure 12 représente le diacrylate de néopentylglycol.
La figure 13 représente une famille de composés dans laquelle:

- avec x=2, on a le diacrylate de pentaerythritol;
- avec x=3, on a le triacrylate de pentaerythritol;
- avec x=4, on a le tétraacrylate de pentaerythritol.

La figure 14 représente le triacrylate de triméthylolpropane.

Exemples de photo-initiateurs

1) Les photo-initiateurs à caractère radicalaire utilisables sont généralement des composés carbonylés contenant des cycles aromatiques formant des radicaux libres par irradiation, les uns par scission intramoléculaire (type I), les autres par abstraction d'hydrogène intermoléculaire (type II). On citera:

a) En type I:
- la benzoïne;
- les éthers de benzoïne;
- l' α, α-diméthoxy α-phényl acétophénone (benzoïne diméthyl éther);
- l' α, α-diéthoxyacétophénone;
- le 1-phényl 1,2-propanedione 2-O-benzoyl oxime.

b) En type II:
- la benzophénone;
- la 4, 4' bis (N, N'-diméthylamino) benzophénone;
- le benzil;
- la xanthone;
- la trioxanthone;
- la 2-chlorothioxanthone;
- la 9,10-anthraquinone;
- la 9,10-phénanthrènequinone.

2) Les photo-initiateurs à caractère ionique utilisables sont généralement:

- des sels à anions complexes halogénés d'aryldiazonium illustrés par la formule développée de la figure 15;
- des sels à anions complexes halogénés de diaryliodonium illustrés par la formule développée de la figure 16;
- des sels à anions complexes halogénés de triarylsulfonium, illustrés par la formule développée de la figure 17, dont la photolyse produit soit des acides de Lewis $MX_{n-1}$ (où X=F ou Cl et M=1 élément métallique ou autre), dans le cas des sels de diazonium, soit des acides de Brönsted ($HMX_n$) dans le cas des sels d'iodonium et de sulfonium, qui initient ensuite la polymérisation de sites insaturés par un mécanisme cationique.

En outre, les compositions selon l'invention peuvent être encore améliorées en ce qui concerne:

- l'adhérence de l'enrobage à la fibre optique, grâce à un agent de pontage, en général un organosilane ou un organosilazane;
- l'inhibition de toute polymérisation purement thermique, grâce à l'incorporation d'un stabilisant dit aussi »inhibiteur thermique«.

Parmi les agents de pontage s'avèrent intéressants les silanes:

- N β-aminoéthyl γ-aminopropyltriméthoxysilane;
- γ-aminopropyl triethoxysilane;
- γ-glycidyl oxypropyl triméthoxysilane.

Parmi les inhibiteurs thermiques, on citera l'hydroquinone et les hydroquinones substituées par des

radicaux alcoxy.

Parmi les avantages de l'invention, on signale la possibilité d'un large choix de composés organiques en vue d'obtenir certaines propriétés physiques de la composition par exemple avant durcissement, la plus ou moins grande viscosité de la solution, ou après durcissement, la dureté du revêtement obtenu.

C'est ainsi que l'utilisation de monomères tri- ou tétra-fonctionnels tels que les pentaerythritol tri- et tétra-acrylates permet d'obtenir un revêtement très dur. Une telle propriété peut être expliquée par la densité relativement forte des sites réactifs.

Les proportions relatives des polymères réactifs et des monomères dans les compositions ne sont pas critiques. Ces proportions peuvent être les suivantes:

- 25 à 75% du poids total pour le ou les polymères réactifs;
- le reste en monomère(s) vinylique(s) compte-tenu de la présence dans le cas de l'utilisation d'un rayonnement ultraviolet de:
  - 1 à 10% de photo-initiateur radicalaire ou plus souvent 1 à 5%;
  - 1 à 10% de photo-initiateur ionique ou plus souvent 1 à 5%.

Une proportion supérieure à 5% pour chaque type de photo-initiateur est de nature à favoriser la vitesse de polymérisation.

Le taux d'inhibiteur thermique est de l'ordre de 0,1 à 0,5% en poids.

Le taux d'agent de pontage est de l'ordre de 1% en poids.

Parmi les autres avantages de l'invention, on signale:

- l'économie d'énergie de chauffage due au fait que le durcissement du revêtement s'effectue à la température ambiante;
- la vitesse du durcissement, celui-ci pouvant être achevé en quelques minutes voire quelques secondes notamment dans l'exemple d'utilisation qui est donné ci-après;
- la possibilité d'obtenir un revêtement sans utiliser de solvant qui doive ensuite être éliminé par exemple, par évaporation, puisque le »solvant« est ici un monomère vinylique liquide qui s'intègre dans la composition finalement obtenue;
- les excellentes qualités de la fibre ainsi revêtue.

## Exemples d'utilisation

Le procédé de revêtement d'une fibre optique, en utilisant une composition selon l'invention, est principalement caractérisé en ce qu'il comporte les étapes suivantes effectuées successivement dans une même installation de tirage d'une fibre optique:

- passage de la fibre dans un dispotif classique d'enrobage dit aussi d'enduction, dans lequel on utilise une composition selon l'invention;
- circulation de la fibre le long de l'axe de focalisation commun à au moins deux dispositifs d'irradiation ultraviolette, par exemple des tubes à vapeur de mercure;
- circulation de la fibre dans un espace à la température ambiante pendant le temps nécessaire à l'achèvement de la polymérisation;
- enroulement de la fibre sur un dispositif de stockage.

A titre d'exemple, on utilise une composition constituée en mélangeant les composés ci-après dans les proportions suivantes (en poids):

- 53% de polyacrylate de glycidyle totalement estérifié par l'acide acrylique (figure 3 avec R = R' = H, X = O) (catégorie A2);
- 14% de acrylate d'épithio-2,-3 propyle (figure 9 avec R = H, X = S) (catégorie B1);
- 14% de diacrylate d'hexanediol-1,-6 (figure 11 avec n = 6) (catégorie B2);
- 8,9% de triacrylate de pentaerythritol (figure 13 avec X = 3) (catégorie B2);
- 5% d'α, α-diméthoxy α-phényl acétophénone (benzoïne dimethyl ether);
- 5% d'hexafluoroantimonate de p-diéthylaminobenzène diazonium;
- 0,1% d'hydroquinone.

On donne ci-dessous un autre exemple de composition utilisable constituée de:

- 46,8% en poids de polyacrylate de thioglycidyle (figure 2 avec R = H et X = S) (catégorie A1);
- 36% de diacrylate d'hexanediol-1,-6 (figure 11 avec n = 6) (catégorie B2);
- 7,1% de triacrylate de pentaerythritol (figure 13 avec X = 3) (catégorie B2);
- 5% d'α, α-dimethoxy α-phenyl acétophénone (benzoïne dimethyl ether);

— 5% d'hexafluoroantimonate de p-diethylamino- benzène diazonium;
— 0,1% d'hydroquinone.

Dans un exemple précis d'application de l'invention au revêtement d'une fibre optique, le dispositif d'enrobage est constitué par un récipient dont le fond possède un tube capillaire de sortie, dans lequel la fibre passe à une vitesse de 40 mètres par minute. La fibre circule ensuite entre deux tubes à vapeur de mercure à moyenne pression de puissance électrique unitaire de 1,9 kW et de 80 W/cm de puissance lumineuse, possèdant une longueur de décharge utile de 212 mm. Les deux tubes sont disposés face à face et leurs axes de focalisation sont confondus; la fibre circule le long de cet axe.
La fibre circule enfin sur une longueur de 1 à quelques mètres avant d'être enroulée.

**Revendications**

1. Composition photopolymérisable, durcissable sous l'effet d'un rayonnement photonique ultra-violet, caractérisée en ce qu'elle comprend:

— au moins un polymère réactif dont la formule chimique comporte au moins un cycle thiirane, ou présente une insaturation éthylénique,
— au moins un monomère vonylique dont la formule chimique comporte un cycle thiirane dans le cas où le polymère réactif n'en comporte pas lui-même,
— au moins deux photo-initiateurs dont l'un a un caractère radicalaire et l'autre un caractère ionique.

2. Composition selon la revendication 1, caractérisée en ce qu'elle comporte les proportions pondérales suivantes:

— 25 à 75% de polymère(s) réactif(s),
— 1 à 10% de photo-initiateur(s) radicalaire(s),
— 1 à 10% de photo-initiateur(s) ionique(s),
— le reste en monomère(s) vinylique(s).

3. Composition selon la revendication 1, caractérisée en ce que le polymère réactif, ou l'un des polymères réactifs est constitué par du polyvinylcinnamate.
4. Composition selon la revendication 1, caractérisée en ce que le polymère réactif, ou l'un des polymères réactifs, est constitué par un polyacrylate de glycidyle modifié en totalité ou en partie par l'acide acrylique ou par l'acide méthacrylique.
5. Composition selon la revendication 1, caractérisée en ce que le polymère réactif, ou l'un des polymères réactifs est constitué par un polyacrylate d'épithio-2,-3 propyle brut ou modifié en totalité ou en partie par l'acide acrylique ou par l'acide méthacrylique.
6. Composition selon la revendication 1, caractérisée en ce que le polymère réactif, ou l'un des polymères réactifs, est constitué par un polyméthacrylate de glycidyle modifié en totalité ou en partie par l'acide acrylique ou par l'acide méthacrylique.
7. Composition selon la revendication 1, caractérisée en ce que le polymère réactif ou l'un des polymères réactifs est constitué par un polyméthacrylate d'épithio-2,-3 propyle brut ou modifié en totalité ou en partie par l'acide acrylique ou par l'acide méthacrylique.
8. Composition selon la revendication 1, caractérisée en ce que le polymère réactif ou l'un des polymères réactifs est constitué par un polymère thiirane obtenu à partir du bisphénol A, non estérifié ou estérifié en totalité ou en partie par l'acide acrylique ou l'acide méthacrylique.
9. Composition selon la revendication 1, caractérisée en ce que le polymère réactif, ou l'un des polymères réactifs est un polymère thiirane obtenu à partir d'alcanediols, en particulier à partir du butanediol-1,-4 ou de l'hexanediol-1,-6 non estérifié ou estérifié en totalité ou en partie par l'acide acrylique ou l'acide méthacrylique.
10. Composition selon la revendication 1, caractérisée en ce que le monomère, ou l'un des monomères, est un monoester, ou un diester, ou un triester, ou un tétraester de l'acide acrylique ou de l'acide méthacrylique.
11. Composition selon la revendication 10, caractérisée en ce que le monomère est l'acrylate de glycidyle.
12. Composition selon la revendication 10, caractérisée en ce que le monomère est l'acrylate d'épithio-2,-3 propyle.
13. Composition selon la revendication 10, caractérisée en ce que le monomère est le méthacrylate de glycidyle.
14. Composition selon la revendication 10, caractérisée en ce que le monomère est le méthacrylate d'épithio-2,-3 propyle.
15. Composition selon la revendication 10, caractérisée en ce que le monomère est le diméthacrylate d'éthylène glycol.

16. Composition selon la revendication 10, caractérisée en ce que le monomère est le diacrylate de diéthylène glycol.
17. Composition selon la revendication 10, caractérisée en ce que le monomère est le diacrylate de triéthylène glycol.
18. Composition selon la revendication 10, caractérisée en ce que le monomère est le diacrylate de butanediol-1,-4.
19. Composition selon la revendication 10, caractérisée en ce que le monomère est le diacrylate d'hexanediol-1,-6.
20. Composition selon la revendication 10, caractérisée en ce que le monomère est le diacrylate de néopentylglycol.
21. Composition selon la revendication 10, caractérisée en ce que le monomère est le diacrylate de pentaerythritol.
22. Composition selon la revendication 10, caractérisée en ce que le monomère est le triacrylate de pentaerythritol.
23. Composition selon la revendication 10, caractérisée en ce que le monomère est le tétraacrylate de pentaerythritol.
24. Composition selon la revendication 10, caractérisée en ce que le monomère est le triacrylate de trimethylolpropane.
25. Composition selon la revendication 1, caractérisée en ce que le photo-initiateur à caractère radicalaire est l'un des composés suivants:

— la benzoïne;
— les éthers de benzoïne;
— l' $\alpha,\alpha$-dimethoxy-phényl acétophenone;
— l' $\alpha,\alpha$-diéthoxyacétophénone;
— le 1-phényl 1,2-propanedione 2-O-benzoyl oxime;
— la benzophénone;
— la 4, 4'bis (N, N'-diméthylamino) benzophénone;
— le benzil;
— la xanthone;
— la trioxanthone;
— la 2-chlorothioxanthone;
— la 9,10-anthraquinone;
— la 9,10-phénanthrènequinone.

26. Composition selon la revendication 1, caractérisée en ce que le photo-initiateur à caractère ionique est l'un des composés ci-après:

— sel d'aryldiazonium à anion complexe halogéné;
— sel de diaryliodonium à anion complexe halogéné;
— sel de triarylsulfonium à anion complexe halogéné.

**Patentansprüche**

1. Photopolymerisierbare, unter der Einwirkung einer ultravioletten Photonenstrahlung härtbare Zusammensetzung, dadurch gekennzeichnet, daß sie enthält:

— mindestens ein reaktives Polymer, dessen chemische Formel mindestens einen Thiiranring oder eine äthylenische Unsättigung aufweist,
— mindestens ein Vinylmonomer, dessen chemische Formel einen Thiiranring aufweist, falls das reaktive Polymer nicht selbst einen solchen aufweist,
— mindestens zwei Photoinitiatoren, von denen der eine einen Radikalcharakter, der andere einen ionischen Charakter besitzt.

2. Zusammensetzung nach Anspruch 1, dadurch gekennzeichnet, daß sie die folgenden Gewichtsverhältnisse aufweist:

— 25 bis 75% reaktiv(es) Polymer(e),
— 1 bis 10% Radikalphotoinitiator(en),
— 1 bis 10% ionische(r) Photoinitiator(en),
— Rest Vinylmonomer(e).

3. Zusammensetzung nach Anspruch 1, dadurch gekennzeichnet, daß das reaktive Polymer oder eines der reaktiven Polymere Polyvinylcinnamat ist.

4. Zusammensetzung nach Anspruch 1, dadurch gekennzeichnet, daß das reaktive Polymer oder eines der reaktiven Polymere ein ganz oder teilweise durch Acrylsäure oder Methacrylsäure modifiziertes Polyglycidylacrylat ist.

5. Zusammensetzung nach Anspruch 1, dadurch gekennzeichnet, daß das reaktive Polymer oder eines der reaktiven Polymere ein rohes oder ganz oder teilweise durch Acrylsäure oder Methacrylsäure modifiziertes Polyepithio-2,3-propylacrylat ist.

6. Zusammensetzung nach Anspruch 1, dadurch gekennzeichnet, daß das reaktive Polymer oder eines der reaktiven Polymere ein ganz oder teilweise durch Acrylsäure oder Methacrylsäure modifiziertes Polyglycidylmethacrylat ist.

7. Zusammensetzung nach Anspruch 1, dadurch gekennzeichnet, daß das reaktive Polymer oder eines der reaktiven Polymere ein rohes oder ganz oder teilweise durch Acrylsäure oder Methacrylsäure modifiziertes Polyepithio-2,3-propylmethacrylat ist.

8. Zusammensetzung nach Anspruch 1, dadurch gekennzeichnet, daß das reaktive Polymer oder eines der reaktiven Polymere ein nicht verestertes oder ganz oder teilweise mit Acrylsäure oder Methacrylsäure verestertes, ausgehend von Bisphenol A erhaltenes Thiiran-Polymer ist.

9. Zusammensetzung nach Anspruch 1, dadurch gekennzeichnet, daß das reaktive Polymer oder eines der reaktiven Polymere ein nicht verestertes oder ganz oder teilweise mit Acrylsäure oder Methacrylsäure verestertes, ausgehend von Alkandiolen, insbesondere von Butandiol-1,4 oder Hexandiol-1,6 erhaltenes Thiiran-Polymer ist.

10. Zusammensetzung nach Anspruch 1, dadurch gekennzeichnet, daß das Monomer oder eines der Monomere ein Monoester, Diester, Triester oder Tetraester der Acrylsäure oder der Methacrylsäure ist.

11. Zusammensetzung nach Anspruch 10, dadurch gekennzeichnet, daß das Monomer Glycidylacrylat ist.

12. Zusammensetzung nach Anspruch 10, dadurch gekennzeichnet, daß das Monomer Epithio-2,3-propylacrylat ist.

13. Zusammensetzung nach Anspruch 10, dadurch gekennzeichnet, daß das Monomer Glycidylmethacrylat ist.

14. Zusammensetzung nach Anspruch 10, dadurch gekennzeichnet, daß das Monomer Epithio-2,3-propylmethacrylat ist.

15. Zusammensetzung nach Anspruch 10, dadurch gekennzeichnet, daß das Monomer Äthylenglykoldimethacrylat ist.

16. Zusammensetzung nach Anspruch 10, dadurch gekennzeichnet, daß das Monomer Diäthylenglykoldiacrylat ist.

17. Zusammensetzung nach Anspruch 10, dadurch gekennzeichnet, daß das Monomer Triäthylenglykoldiacrylat ist.

18. Zusammensetzung nach Anspruch 10, dadurch gekennzeichnet, daß das Monomer Butandiol-1,4-diacrylat ist.

19. Zusammensetzung nach Anspruch 10, dadurch gekennzeichnet, daß das Monomer Hexandiol-1,6-diacrylat ist.

20. Zusammensetzung nach Anspruch 10, dadurch gekennzeichnet, daß das Monomer Neopentylglykoldiacrylat ist.

21. Zusammensetzung nach Anspruch 10, dadurch gekennzeichnet, daß das Monomer Pentaerythritdiacrylat ist.

22. Zusammensetzung nach Anspruch 10, dadurch gekennzeichnet, daß das Monomer Pentaerythrittriacrylat ist.

23. Zusammensetzung nach Anspruch 10, dadurch gekennzeichnet, daß das Monomer Pentaerythrittetracrylat ist.

24. Zusammensetzung nach Anspruch 10, dadurch gekennzeichnet, daß das Monomer Trimethylolpropantriacrylat ist.

25. Zusammensetzung nach Anspruch 1, dadurch gekennzeichnet, daß der Photoinitiator mit Radikalcharakter eine der folgenden Verbindungen ist:

- Benzoin,
- Äther des Benzoins,
- $\alpha,\alpha$-Dimethoxy-$\alpha$-phenyl-acetophenon,
- $\alpha,\alpha$-Diäthoxyacetophenon,
- 1-Phenyl-1,2-propandion-2-O-benzoyl-oxim,
- Benzophenon,
- 4,4'-bis-(N,N'-Dimethylaminobenzophenon,
- Benzil,
- Xanthon,
- Trioxanthon,
- 2-Chlorthioxanthon,
- 9,10-Anthrachinon,

— 9,10-Phenanthrenchinon.

26. Zusammensetzung nach Anspruch 1, dadurch gekennzeichnet, daß der Photoinitiator mit ionischem Charakter eine der folgenden Verbindungen ist:

— Aryldiazoniumsalz mit komplexem halogeniertem Anion,
— Diaryliodoniumsalz mit komplexem halogeniertem Anion,
— Triarylsulfoniumsalz mit komplexem halogeniertem Anion.

**Claims**

1. Composition being photopolymerizable and hardenable under the effect of an ultraviolet photon radiation characterized by comprising:

— at least one reactive polymer the chemical formula of which bears at least one thiirane ring or presents an ethylenic unsaturation,
— at least one vinylic monomer the chemical formula of which bears a thiirane ring in case said reactive polymer itself does not comprise any such ring,
— at least two photo-initiators, the one with radical character and the other with ionic character.

2. Composition according to claim 1 characterized by having the following weight ratios:

— 25 to 75% of reactive polymer(s),
— 1 to 10% of radical photo-initiator(s),
— 1 to 10% of ionic photo-initiator(s),
— balance of vinylic monomer(s).

3. Composition according to claim 1 characterized in that said reactive polymer or one of said reactive polymers is polyvinyl cinnamate.

4. Composition according to claim 1 characterized in that said reactive polymer or one of said reactive polymers is polyglycidyl acrylate totally or partially modified by acrylic acid or methacrylic acid.

5. Composition according to claim 1 characterized in that said reactive polymer or one of said reactive polymers is a polyepithio-2,3-propyl acrylate, the latter being crude or totally or partially modified by acrylic acid or methacrylic acid.

6. Composition according to claim 1 characterized in that said reactive polymer or one of said reactive polymers is a polyglycidyl methacrylate totally or partially modified by acrylic acid or methacrylic acid.

7. Composition according to claim 1 characterized in that said reactive polymer or one of said reactive polymers is a polyepithio-2,3-propyl methacrylate, the latter being crude or totally or partially modified by acrylic acid or methacrylic acid.

8. Composition according to claim 1 characterized in that said reactive polymer or one of said reactive polymers is a thiirane polymer obtained by starting from bisphenol A and being non-esterified or totally or partially esterified by acrylic acid or methacrylic acid.

9. Composition according to claim 1 characterized in that said reactive polymer or one of said reactive polymers is a thiirane polymer obtained by starting from alkanediols, especially from butanediol-1,4 or hexanediol-1,6 and being non-esterified or totally or partially esterified by acrylic acid or methacrylic acid.

10. Composition according to claim 1 characterized in that said monomer or one of said monomers is a monoester, a diester, a triester, or a tetraester of acrylic acid or methacrylic acid.

11. Composition according to claim 10 characterized in that said monomer is glycidyl acrylate.

12. Composition according to claim 10 characterized in that said monomer is epithio-2,3-propyl acrylate.

13. Composition according to claim 10 characterized in that said monomer is glycidyl methacrylate.

14. Composition according to claim 10 characterized in that said monomer is epithio-2,3-propyl methacrylate.

15. Composition according to claim 10 characterized in that said monomer is ethylene glycol dimethacrylate.

16. Composition according to claim 10 characterized in that said monomer is diethylene glycol diacrylate.

17. Composition according to claim 10 characterized in that said monomer is triethylene glycol diacrylate.

18. Composition according to claim 10 characterized in that said monomer is butanediol-1,4 diacrylate.

19. Composition according to claim 10 characterized in that said monomer is hexanediol-1,6 diacrylate.

20. Composition according to claim 10 characterized in that said monomer is neopentyl glycol diacrylate.

21. Composition according to claim 10 characterized in that said monomer is pentaerythritol diacrylate.

22. Composition according to claim 10 characterized in that said monomer is pentaerythritol triacrylate.

23. Composition according to claim 10 characterized in that said monomer is pentaerythritol tetraacrylate.

24. Composition according to claim 10 characterized in that said monomer is trimethylol propane triacrylate.

25. Composition according to claim 1 characterized in that said photo-initiator with radical character is one of the following compounds:

- benzoin,
- benzoin ethers,
- α,α-dimethoxy-α-phenyl-acetophenone,
- α,α-diethoxyacetophenone,
- 1-phenyl-1,2-propanedione-2-O-benzoyl-oxime,
- benzophenone,
- 4,4'-bis-(N,N'-dimethylaminobenzophenone,
- benzil,
- xanthone,
- trioxanthone,
- 2-chlorothioxanthone,
- 9,10-anthraquinone,
- 9,10-phenanthrene quinone.

26. Composition according to claim 1 characterized in that said photo-initiator with ionic character is one of the following compounds:

- aryl diazonium salt having a complex halogenated anion,
- diaryl iodonium salt having a complex halogenated anion,
- triaryl sulphonium salt having a complex halogenated anion.

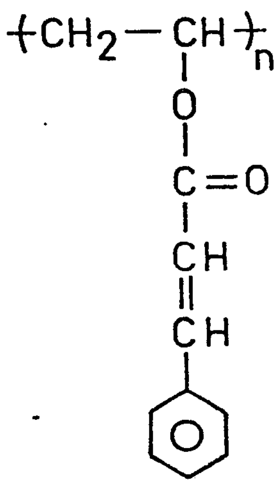

FIG.1

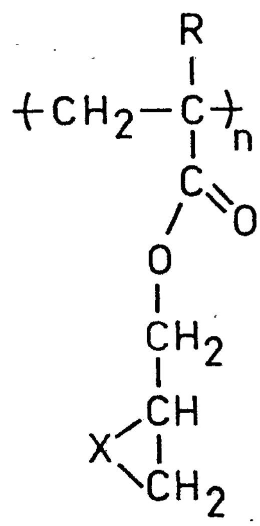

FIG.2

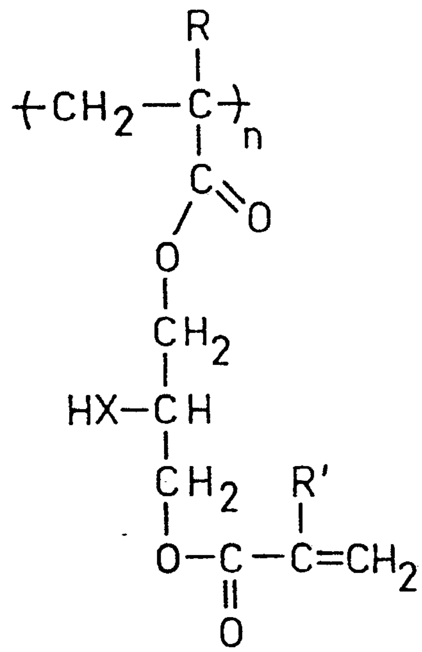

FIG.3

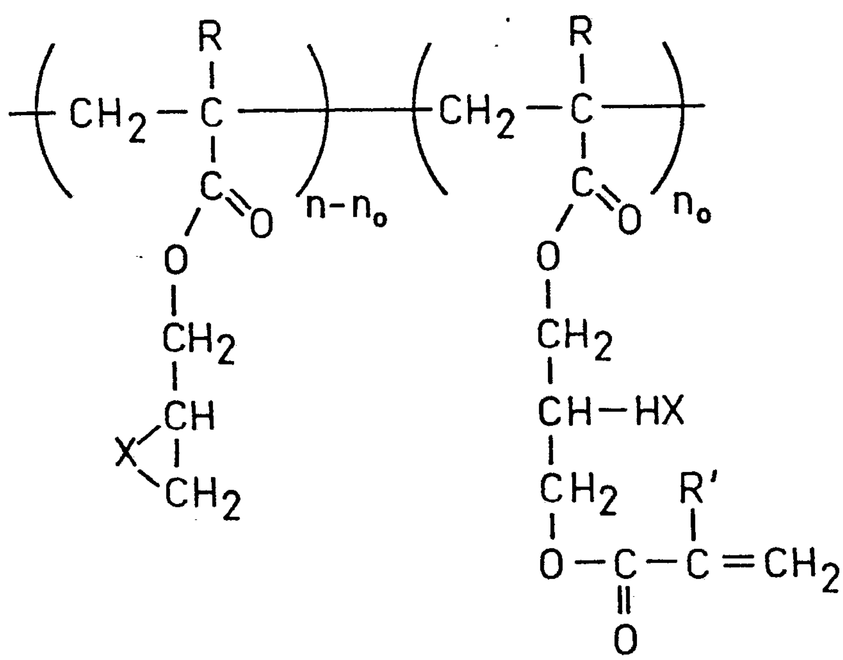

FIG.4

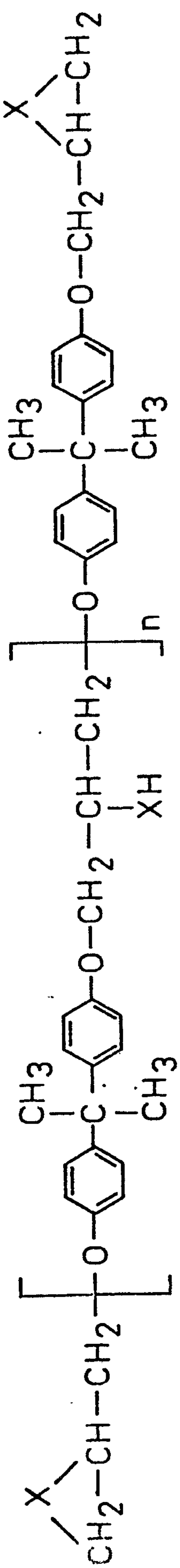

FIG.5

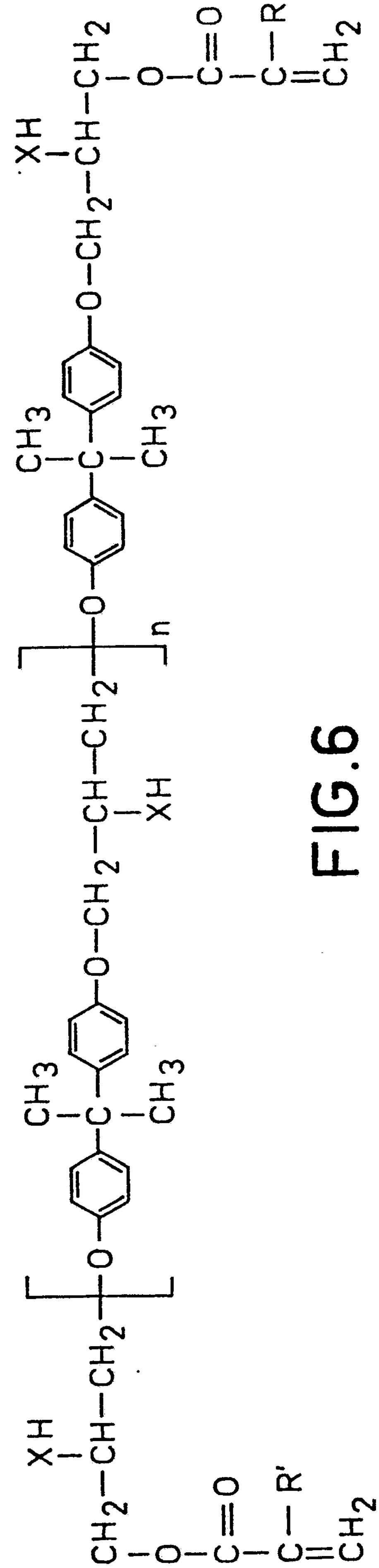

FIG.6

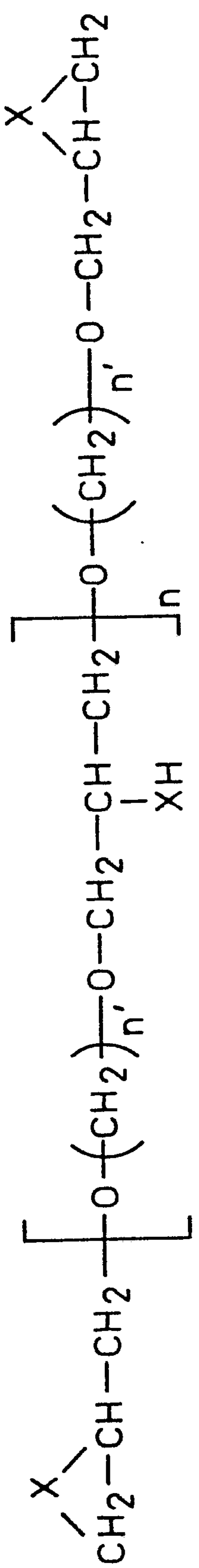

FIG.7

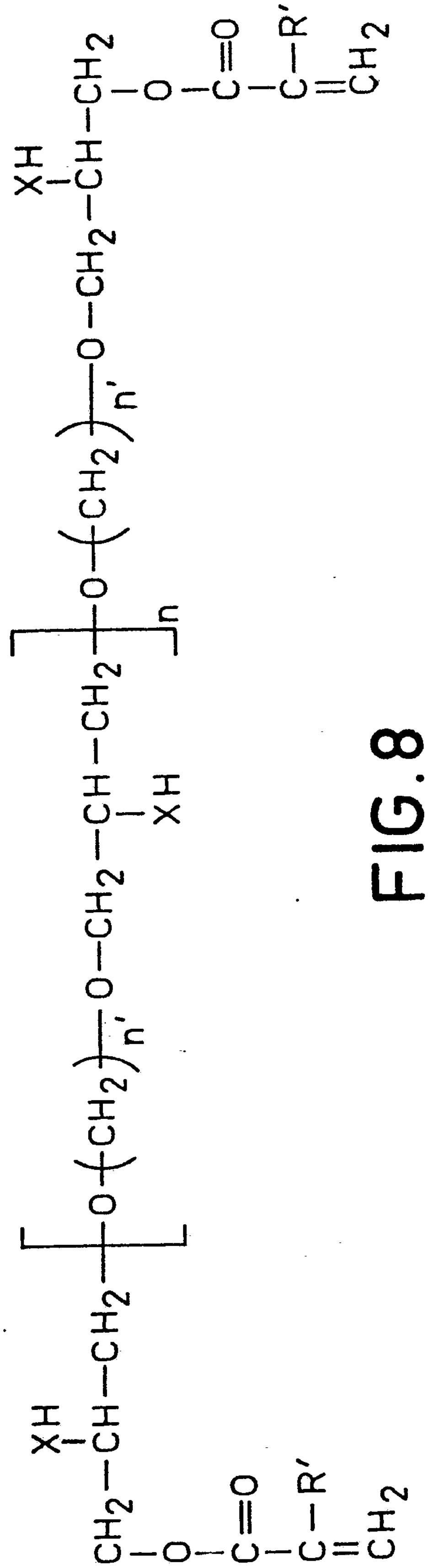

FIG.8

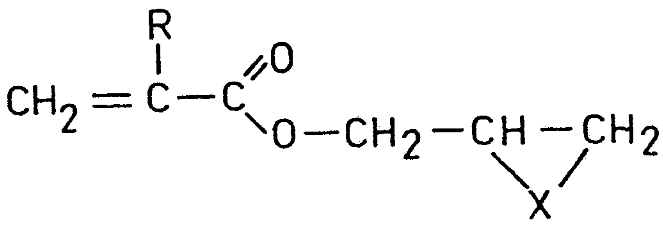

FIG.9

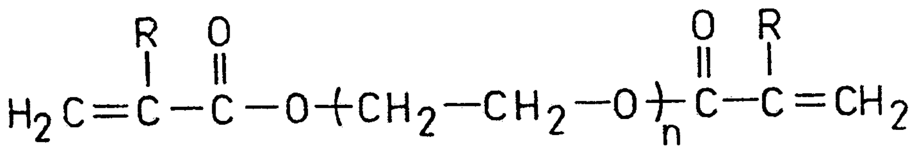

FIG.10

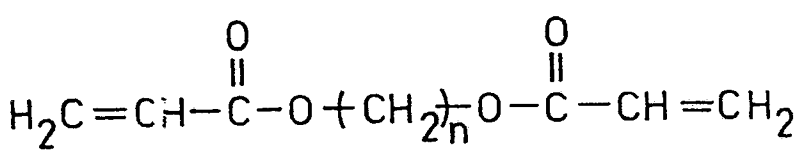

FIG.11

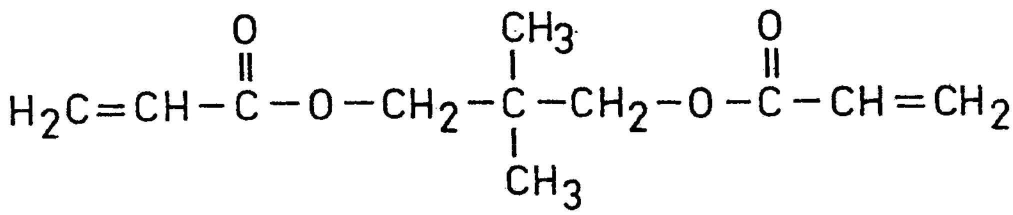

FIG.12

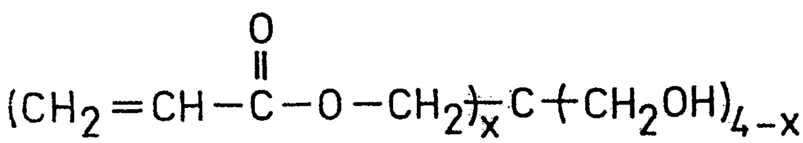

FIG.13

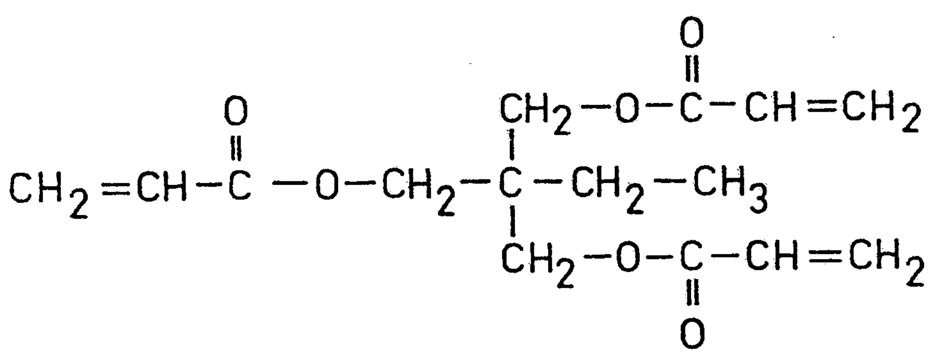

FIG.14

FIG.15 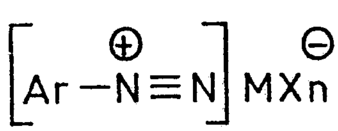

FIG.16 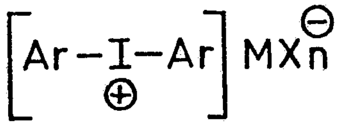

Ar: Radical Aryle
M: Métal ou autre élément
X: F,Cl

FIG.17